# EUROPÄISCHE PATENTSCHRIFT

(11) **EP 1 920 461 B1**
(45) Veröffentlichungstag und Bekanntmachung des Hinweises auf die Patenterteilung: **16.11.2016**
(21) Anmeldenummer: 06792559.4
(22) Anmeldetag: 24.07.2006
(51) Int. Cl.: H01L 21/768, H01L 21/302

(54) **VERFAHREN ZUR ERZEUGUNG VON DURCHKONTAKTIERUNGEN IN HALBLEITERWAFERN**
METHOD FOR PRODUCING THROUGH-CONTACTS IN SEMI-CONDUCTOR WAFERS
Procédé de fabrication d'interconnexions verticales dans des plaquettes semi-conductrices

(30) Priorität: 31.08.2005 DE 102005042074
(43) Veröffentlichungstag der Anmeldung: 14.05.2008
(73) Patentinhaber: Forschungsverbund Berlin e.V., 12489 Berlin (DE)
(72) Erfinder: KRUEGER, Olaf, 12524 Berlin (DE); SCHOENE, Gerd, 12524 Berlin (DE); JOHN, Wilfred, 12527 Berlin (DE); WERNICKE, Tim, 10249 Berlin (DE); WUERFL, Joachim, 15738 Zeuthen (DE)
(74) Vertreter: Gulde & Partner
(86) Internationale Anmeldenummer: PCT/EP2006/064599
(87) Internationale Veröffentlichungsnummer: WO 2007/025812

(56) Entgegenhaltungen:
- US-A1- 2001 035 580
- US-A1- 2004 072 422
- US-A1- 2004 188 819
- KIM ET AL.: "SiC Via Holes by Laser Drilling" JOURNAL OF ELECTRONIC MATERIALS, Bd. 33, Nr. 5, Mai 2004 (2004-05), Seiten 477-480, XP008070388

## Beschreibung

Die Erfindung betrifft ein Verfahren zur Erzeugung von vertikalen Durchkontaktierungen (Mikro-Vias, Sacklochvias oder "blind" vias, via = vertical interconnect access) in Halbleiterwafern zur Herstellung von Halbleiter-Bauelementen, das heißt von Kontakten auf der Wafer-Vorderseite durch den Halbleiter-Wafer hindurch zur Wafer-Rückseite.

Die vollständige Ausnutzung der Eigenschaften (zum Beispiel Hochfrequenzeigenschaften) der Bauelemente kann nur durch eine immer kompaktere Integration in die Peripherie erreicht werden. Kurze vertikale Verbindungen stellen einen effizienten Weg der elektrischen Kontaktierung dar. Außerdem ist es aus physikalischen Gründen erforderlich, zur Erhöhung der Verstärkung und der maximal pro Chip verfügbaren Ausgangsleistung von Hochleistungstransistoren eine elektrisch leitende Verbindung mit niedriger Induktivität zwischen den Source-Kontakten auf der Vorderseite und der Masseelektrode auf der Rückseite herzustellen. Dies lässt sich jedoch technologisch nicht immer leicht realisieren.

Elektrisch aktives GaN-Material (Galliumnitrid) steht derzeit praktisch nicht als einkristallines Wafermaterial zur Verfügung und wird daher epitaktisch auf Substratmaterialien wie zum Beispiel SiC-Wafern (Siliciumcarbid) gewachsen.

SiC zeichnet sich durch eine sehr gute Wärmeleitfähigkeit sowie eine extrem hohe chemische Stabilität und hohe Härte aus. Für eine Rückseitenkontaktierung von GaN-Transistoren besteht also die Notwendigkeit, das Trägermaterial aus SiC sowie die darüber liegende GaN-Epitaxieschicht zu durchbohren. Für eine Strukturierung kamen bisher praktisch nur trockenchemische Ätzverfahren wie reaktives Ionenätzen in eigens dafür optimierten Hochleistungs-Plasmaätzreaktoren in Frage. Typische Plasma-Ätzraten von SiC sind aber mit 1 µm/min sehr klein. Der Einsatz der Plasmaätztechnik setzt zudem die Herstellung und lithographische Strukturierung einer widerstandsfähigen Ätzmaske voraus.

Es ist bekannt, dass sich in Leiterplatten Vias durch den Einsatz von Lasern herstellen lassen. Bei diesen Technologien werden mit dem Laser Öffnungen in die Kupfer- und Dielektrika-Schichten gebohrt und diese dann metallisiert, um elektrische Verbindungen zwischen bestimmten Lagen herzustellen. Die unterschiedlichen Lasertechnologien basieren auf dem Einsatz von CO₂-Lasern, frequenzverdoppelten (grünen) YAG-Lasern, Excimerlasern und UV:YAG-Lasern.

Die Herstellung dieser Vias ist beispielsweise beschrieben in:
- L. W. Burgess: "Introducing Via-in-Pad Blind Via Technology to Any PCB Multilayer Fabricator." IPC Printed Circuits Expo 1997, March 9-13, 1997, San Jose, CA, S15-2.
- A. Cable: "Improvements in High Speed Laser Microvia Formation Using Solid State Nd:YAG UV Lasers." IPC Printed Circuits Expo 1997, March 9-13, 1997, San Jose, CA, S17-7.
- M.D. Owen: "Via drilling." In: J.F. Ready, D.F. Farson (Edtrs.): LIA Handbook of laser materials processing, Laser Institute of America, Magnolia Publishing (2001) 661-665.

US 2001/035580 A1 beschäftigt sich mit der Durchkontaktierung von GaN-Halbleiterbauelementen auf Saphir- oder SiC-Substraten und kann zur Veranschaulichung des technischen Hintergrundes der Erfindung dienen.

Für die Erzeugung von Mikro-Vias in Halbleiterwafern ist aus der US 2001/0035580 A1 eine Methode auf der Grundlage einer Lasertechnologie bekannt.

Der Erfindung liegt die Aufgabe zugrunde, ein effektives Verfahren zur Erzeugung von Mikro-Vias in Halbleiterwafern, insbesondere aus Materialien hoher Härte und chemischer Stabilität wie Siliciumcarbid, Saphir oder ähnlichem, anzugeben.

Erfindungsgemäß wird die Aufgabe gelöst durch ein Verfahren mit den Merkmalen des Anspruchs 1. Zweckmäßige Ausgestaltungen sind Gegenstand der Unteransprüche.

Danach ist das Verfahren gekennzeichnet durch die folgenden Schritte:
- Laserbohren von Sacklöchern an den Kontaktverbindungsstellen von der Wafer-Rückseite her in das Halbleitersubstrat
- Reinigung des Wafers (Entfernung des Debris)
- materialselektives Plasmaätzen des Halbleitersubstrates bis zum aktiven Schichtstapel des Wafers
- materialselektives Plasmaätzen des aktiven Schichtstapels des Wafers bis zum Erreichen der mit der Wafer-Rückseite zu verbindenden Kontakte
- Aufbringen einer Plattierbasis auf die Wafer-Rückseite und in die in einem vorhergehenden Schritt erzeugten Sacklöcher
- galvanischer Goldauftrag auf die metallisierte Wafer-Rückseite und die in einem vorhergehenden Schritt mit einer Plattierbasis versehenen Sacklöcher

Um den Wafer während des Prozesses zu schützen, kann vorsorglich ein Schutzlack auf die Wafer-Vorderseite aufgebracht werden, der nach dem Prozess wieder entfernt wird (Ablacken).

Um ein Abdünnen des Halbleitersubstrates beim Ätzen zu vermeiden, kann die Wafer-Rückseite vor dem Laserbohren der Sacklöcher mit Indium-Zinn-Oxid (ITO) beschichtet werden, das nach dem Plasmaätzen einfach wieder entfernt werden kann.

Die Reinigung des Wafers zum Entfernen des Debris erfolgt im Falle von SiC-Substratmaterial zweckmäßig mit gepufferter Flusssäure.

Als materialselektives Ätzverfahren für das Halbleitersubstrat eignet sich bevorzugt das ICP-Ätzverfahren (inductivelycoupled plasma), für den Schichtenstapel das RIE-Verfahren (reactiv ion etching).

Als Laser eignet sich ein UV-Laser, bevorzugt ein frequenzverdreifachter Nd:YAG-Laser mit einer Wellenlänge von 355 nm.

Das Aufbringen der Plattierbasis in die Mikro-Vias kann mit mehreren Methoden erfolgen. Bevorzugt wird eine Schrägbedampfung, eine chemische Badabscheidung (stromlos) oder ein Aufsputtern sind ebenfalls möglich.

Im Bedarfsfall kann auf die Goldschicht lokal an den Mikro-Vias noch eine Antibenetzungsschicht (Dewettingschicht) aufgebracht werden. Für die Dewettingschicht wird zweckmäßig Titan verwendet, das aufgesputtert werden kann. Der Auftrag der Antibenetzungsschicht erfolgt zweckmäßig mit Hilfe einer Schattenmaske.

Das Verfahren hat den Vorteil, dass Mikro-Vias in harten und chemisch inerten Substratmaterialien mit wesentlich verringertem Zeitaufwand und mit hoher Präzision erzeugt werden können.

Mit dem erfindungsgemäßen Verfahren wird die Methode der Mikromaterialbearbeitung mittels UV-Laserstrahlung in Kombination mit Plasmaätzen ausgenutzt und für die direkte Strukturierung in der Bauelementefertigung eingesetzt. Im Gegensatz zur Erzeugung von Durchgangs-Vias (oder Hohlnieten-Vias) erfolgt hier keine vollständige Durchbohrung des Materials. Durch Plasmaätzen wird das Restmaterial bis zu den Kontakten der Vorderseite materialselektiv entfernt. Der besondere Vorteil liegt darin, dass eine widerstandsfähige

Ätzmaske nicht lithografisch erzeugt werden muss, sondern die lasergebohrten Löcher als Ätzmaske dienen. Wenn die Bearbeitungsseite in geeigneter Weise geschützt wird, bleibt die Materialdicke erhalten. Eine Schutzschicht, die durch den Laser mit durchbohrt wird, verhindert in diesem Fall den flächigen Materialabtrag beim Plasmaätzen. Bei Verzicht auf die Schutzschicht, erfolgt ein großflächiger Ätzabtrag. Die damit einhergehende Abnahme der Materialdicke kann über die bekannten Ätzraten abgeschätzt werden.

Die Erfindung soll anhand eines Ausführungsbeispiels näher erläutert werden. Die zugehörigen schematischen Zeichnungen zeigen die Phasen des erfindungsgemäßen Verfahrens am Beispiel einer Erzeugung von Mikro-Vias in Siliciumcarbid (SiC) für GaN-Hochleistungs-Feldeffekttransistoren oder MMICs, und zwar in
- Fig. 1: den allgemeinen Aufbau eines Wafers mit einem Durchgangsloch (Via) im Querschnitt,
- Fig. 2 bis Fig. 8: die einzelnen Schritte des Verfahrens,
- Fig. 9: den Wafer mit den fertigen Mikro-Vias im Querschnitt und
- Fig. 10 bis Fig. 14: die Schritte einer zweiten Variante des Verfahrens.

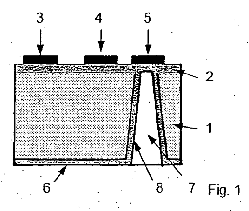

In Fig. 1 ist ein Wafer mit einem Transistoraufbau im Querschnitt gezeigt. Der Wafer besteht aus einem SiC-Substrat 1 von ca. 250 bis 400 µm Dicke, auf dem ein AlGaN/GaN-Schichtenstapel 2 von ca. 2 bis 3 µm Dicke epitaktisch aufgewachsen ist. Auf der Vorderseite des Wafers befinden sich auf dem Schichtenstapel 2 die Anschlusskontakte eines Transistors, nämlich ein Drain-Kontakt 3, ein Gate-Kontakt 4 und ein Source-Kontakt 5. Das Potential des Source-Kontakts 5 muss auf die Rückseite (Masseelektrode 6) des Wafers zurückgeführt werden, was mit Hilfe eines Mikro-Vias 7 erfolgt, dessen Lochwände 8 metallisiert sind, so dass der Source-Kontakt 5 auf der Vorderseite mit der Masseelektrode 6 auf der Rückseite des Wafers elektrisch verbunden wird.

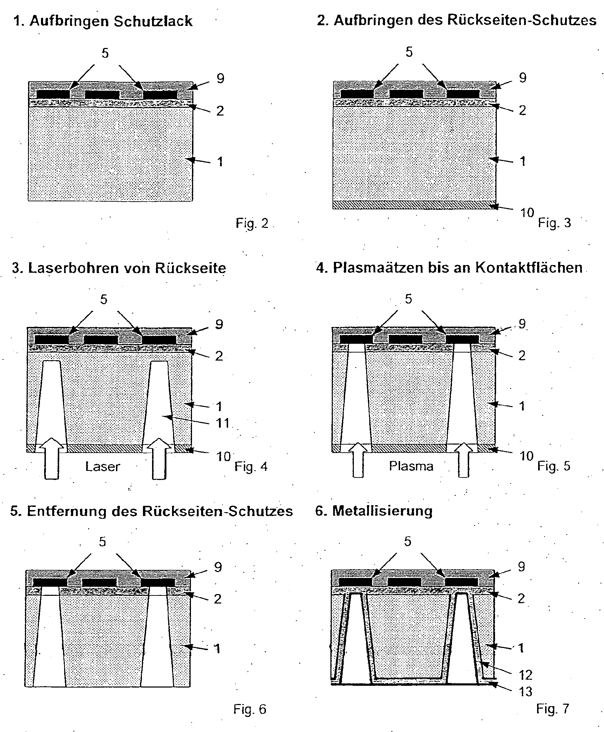

Im Folgenden sollen die Prozessführung des erfindungsgemäßen Verfahrens und die erzielten Resultate beschrieben werden. Die Prozessfolge ist in den Fig. 2 bis 8 schematisch dargestellt. Die fertig prozessierten GaN-Transistoren oder MMICs werden im Waferverbund mit den Mikro-Vias 7 versehen. Zunächst wird auf die Wafer-Vorderseite ein Schutzlack 9 aufgebracht, um die Wafer bei den folgenden Verfahrensschritten zu schützen (Fig. 2). Anschließend wird die Rückseite großflächig mit einer 2 µm dicken Schutzschicht 10 aus Indium-Zinn-Oxid (ITO) belegt (Fig. 3). Dieser Schritt ist jedoch nur notwendig, wenn sich die Dicke des Wafers bei der Strukturierung der Mikro-Vias 7 nicht ändern soll. Diese Schutzschicht 10 dient dann als Schutz der SiC-Oberfläche beim Ätzen und wird beim nachfolgenden Bohren durch einen Laser an den Via-Eintrittsöffnungen mit entfernt. Jetzt werden mit dem Laser Sacklöcher 11 von der Rückseite des Wafers her gebohrt (Fig. 4). Zur Herstellung der gewünschten Sacklöcher 11 wird der Laserstrahl, der einen Durchmesser von ca. 15 µm hat, zweckmäßig auf dem Wafer bewegt. Die Strahlbewegung und Laserparameter lassen sich so einstellen, dass ein möglichst ebenes Bodenprofil in der Nähe der SiC/GaN-Grenzfläche entsteht.

Lockere Partikel die sich beim Bohrprozess auf der Probe niederschlagen (Debris), werden anschließend in einem nasschemischen Reinigungsschritt entfernt. Hierzu eignet sich das Ätzen in gepufferter Flusssäure mit Ultraschall.

Die mit dem Laser vorgebohrten Sacklöcher 11 werden anschließend durch Plasmaätzen bis an die Vorderseitenkontakte trockenchemisch durchgeätzt (Fig. 5). Zweckmäßig wird das restliche SiC mittels ICP-Ätzen in fluorhaltigen Gasgemischen (zum Beispiel Schwefelhexafluorid-Sauerstoff-Helium - SF₆-O₂-He) entfernt. Durch Optimierung der Ätzparameter (Partialdrucke, Temperatur) lassen sich glatte Lochwände erhalten. Die Selektivität des Ätzprozesses von SiC vs. GaN ist >100:1, das heißt es lässt sich eine gute Homogenität der Ätzung über einen Wafer herstellen, da der Ätzprozess am GaN (Dicke ca. 2-3 µm) praktisch zum Halt kommt.

Die Entfernung der 2-3 µm dünnen Epitaxieschicht aus AlGaN/GaN (Schichtenstapel 2) erfolgt plasmachemisch mit einem RIE-Verfahren, zum Beispiel mit Bortrichlorid-Chlor (BCl₃-Cl₂). Die Selektivität des trockenchemischen Ätzprozesses von GaN vs. Platin ist >10:1. Die Metallschicht des Vorderseitenkontaktes mit einer Gesamtdicke von ca. 5 µm wird also nur sehr langsam abgetragen, d.h. der Ätzprozess stoppt praktisch an der Metallschicht. Eine Unterätzung tritt nicht auf. Eine unter den Platinkontakten liegende Titanschicht von einigen 10 nm wird mit abgetragen.

Nach dem Ätzvorgang kann die eventuell aufgebrachte Schicht 10 (ITO) wieder entfernt werden, was zweckmäßig mit Eisen-III-Chlorid erfolgt (Fig 6).

Auf die Wafer-Rückseite wird nachfolgend eine dünne Metallschicht 12 aufgedampft. Dabei wird nach diesem Ausführungsbeispiel durch Schrägbedampfung eine geschlossene Belegung der Lochwände erzielt. Andere Metallisierungsprozesse wie Sputtern oder eine stromlose chemische Abscheidung sind ebenfalls möglich. Die durch die Metallschicht 12 erhaltene Plattierbasis wird anschließend durch eine typisch 5 µm dicke Goldschicht 13 galvanisch verstärkt (Fig. 7). Auf diese Weise wird eine elektrische Verbindung von der einen Waferseite zur anderen Seite mit einer geschlossenen Goldschicht 13 hergestellt.

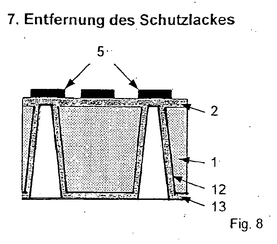

Nach dem Metallisieren erfolgt in einem weiteren Prozessschritt das Ablacken des Schutzlackes 9 (Fig. 8).

Bei Bedarf kann an den Via-Eintrittsöffnungen auf der Rückseite noch eine Antibenetzungsschicht 14 aus Titan aufgebracht werden, nämlich eine 100 nm dünne Titanschicht, die auf die vorhandene Goldschicht 13 gesputtert wird. Die Antibenetzungsschicht 14 wird mit Hilfe einer Schattenmaske strukturiert auf den Wafer aufgebracht. Die Schattenmaske besteht aus einer 0.1 mm dicken Metallfolie, in die mit dem Laser Öffnungen gebohrt werden. Das Layout der Öffnungen in der Metallfolie entspricht der Anordnung der Mikro-Vias 7 auf dem Wafer. Die Durchmesser der Öffnungen in der Schattenmaske sind etwas größer als der Eintrittsdurchmesser der Mikro-Vias 7 auf der Wafer-Rückseite, so dass sich ein etwa 40 µm breiter Titan-Ring um die Via-Eintrittsöffnungen ausbildet. Mit Hilfe von je vier zusätzlichen Durchgangsbohrungen am Rand von Schattenmaske und Wafer werden beide Teile mittels Passstiften zueinander justiert, das heißt deckungsgleich gebracht.

Es ist anzumerken, dass das Ablacken des Schutzlacks 9 auch erst nach der Abscheidung der Antibenetzungsschicht 14 (Titan-Dewettingschicht) erfolgen kann.

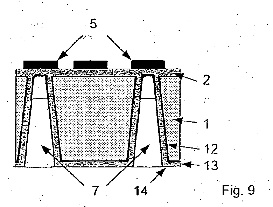

Eine schematische Darstellung der fertigen Mikro-Vias 7 im Querschnitt zeigt Fig. 9.

Auf die ITO-Maskierung der Oberfläche (Schutzschicht 10) kann auch verzichtet werden, falls eine kontrollierte Abnahme der Materialdicke beim Ätzprozess akzeptabel ist, das heißt die Schritte gemäß den Fig. 3 und 6 entfallen.

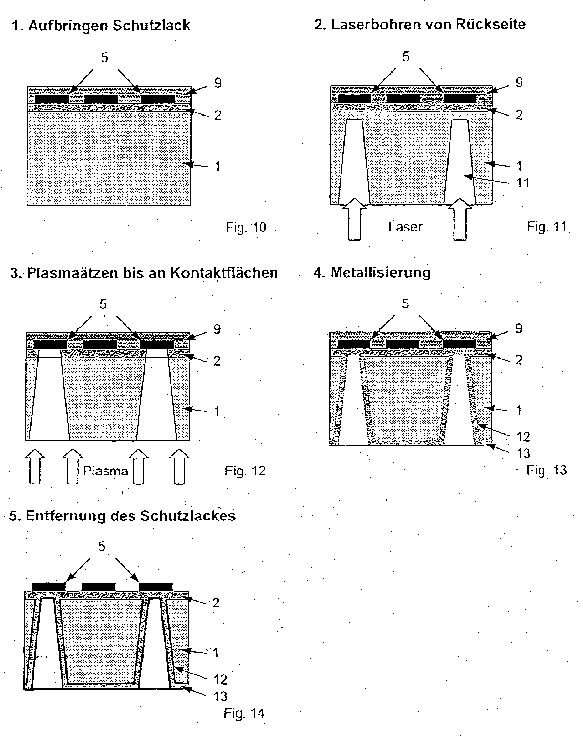

Der Prozessablauf für diesen Fall wird anhand der Fig. 10 bis 14 demonstriert. Die Prozessschritte entsprechen dann den Prozessschritten 1, 3, 4, 6 und 7 des ersten Beispiels (entsprechend den Figuren 2, 4, 5, 7 und 8).

In diesem Fall nimmt die Gesamtdicke des Wafers durch die großflächige Entfernung des SiC ab. Bei einer Ätzdauer von ca. 2 h wird der Wafer von 390 µm auf 250-300 µm abgedünnt. Am Lochboden wird eine Kantenlänge von 35-70 µm erhalten, wobei die Ecken hexagonal aufgeweitet sind. Die Lochform ist konisch mit einer deutlichen Aufweitung des Querschnittes am Eintritt, wodurch die nachträgliche Belegung der Lochwand mit Metall erleichtert wird.

Im Hinblick auf Abtragsrate, Flexibilität und Zuverlässigkeit ist ein frequenzverdreifachter Nd:YAG-Laser für die Bearbeitung des sehr harten und chemisch inerten SiC gut geeignet. Dieser Laser liefert Nanosekundenpulse mit hoher Energie im ultravioletten Spektralbereich bei einer Wellenlänge von 355 nm mit Pulsfrequenzen von bis zu 100 kHz. Der Laserstrahl wird durch Kombination der CNC-gesteuerten Bewegung des Probentisches und der Strahlablenkung mit einem Galvo-Scanner mikrometergenau bewegt. Mit Hilfe einer Bilderkennung und eines hochgenauen luftgelagerten XY-Kreuztisches kann der Laserstrahl mit einer Genauigkeit von ±1 µm in bezug auf vorhandene Strukturen auf dem Werkstück positioniert werden. Diese Präzision wird auch erreicht, wenn die Laserstrukturierung auf der Rückseite erfolgt und sich die Justagemarken auf der (untenliegenden) Vorderseite befinden.

Mit dem Laser wurden Sacklöcher gebohrt, die einen quadratischen Querschnitt und einen möglichst ebenen Lochboden haben. Die Kantenlänge betrug ca. 75 µm an der Lasereintrittsöffnung, am Lochboden betrug sie ca. 15 µm, ca. 40 µm SiC blieben unterhalb des Lochbodens stehen.

Es wurde ein automatisiertes Bohrverfahren verwendet, bei dem die jeweilige Bearbeitungsstelle der Probe durch präzises Verfahren des Probentisches mikrometergenau unter dem Strahlaustritt positioniert wird und der Laserstrahl dann durch ein Spiegelsystem (Galvo-Scanner) schnell auf dem Werkstück bewegt wird, wobei 250-450 µm dickes SiC verwendet wurde. Im Rasterelektronenmikroskop lässt sich gut erkennen, dass die lasergebohrten Löcher leicht konisch sind und sich eine glatte Wand mit wenig Ablagerungen erzeugen lässt.

Widerstandsmessungen an einer SiC-Probe belegen, dass sich eine niederohmige Verbindung zwischen beiden Seiten herstellen lässt. Dazu wurden Proben vor der Via-Prozessierung zunächst auf einer Seite ganzflächig mit einer 5 µm dicken Goldschicht metallisiert. Von der anderen Seite wurde wie oben beschrieben eine Matrix von Vias erzeugt. Der Lochabstand betrug 500 µm. Vor der Messung des Widerstandes durch ein einzelnes Loch mussten die einzelnen Löcher dann noch elektrisch voneinander separiert werden. Dazu wurde die Goldschicht durchtrennt (geritzt), um 500x500 µm² große Felder mit je einem Via zu erhalten. Es konnte gezeigt werden, dass die Kontaktierung durch die SiC-Probe hindurch mit guter Reproduzierbarkeit und sehr homogen realisiert wurde. Die Widerstandswerte liegen bei 25-31 mΩ. Der Mittelwert über die 206 Mikro-Vias liegt bei 27±2 mΩ. Die realisierten Hohlnieten haben ein Aspektverhältnis von 3-4.

In Tests an aufgebauten Transistoren verschiedenen Typs wurde die Funktionstüchtigkeit der Bauelemente nachgewiesen. Anhand der Transistor-Kennlinien wurde der Nachweis für die erfolgreiche Implementierung des Laserbohrens von Mikro-Vias in die GaN-Prozesstechnologie geführt.

Die technologischen Untersuchungen zeigen die Machbarkeit von lasergebohrten Mikro-Vias durch einkristallines SiC-Wafermaterial für GaN-Hochleistungs-Feldeffekttransistoren. Es konnte nachgewiesen werden, dass sich die Lasermikrostrukturierung in die Bauelemente-Prozesstechnologie erfolgreich implementieren lässt.

Voraussetzung für die Anwendung der Laser-Mikrobearbeitung in der Prozessierung von Halbleiter-Wafern ist eine hohe Positioniergenauigkeit des Strahlmittelpunktes von ± 1µm und besser. Diese Genauigkeit bezieht sich auf die Strahlpositionierung relativ zu vorhandenen Bauelementestrukturen und muss sowohl bei der Bearbeitung von der Vorderseite wie auch von der Rückseite erzielt werden.

Die Erfindung ermöglicht Durchkontaktierungen durch das sehr harte und chemisch beständige Siliciumcarbid. Ein Aspektverhältnis von 3-4 wurde hierfür demonstriert.

### Bezugszeichenliste

- 1: SiC-Substrat
- 2: AlGaN/GaN-Schichtenstapel
- 3: Drain-Kontakt
- 4: Gate-Kontakt
- 5: Source-Kontakt
- 6: Masseelektrode
- 7: Mikro-Via
- 8: Lochwand
- 9: Schutzlack
- 10: Schutzschicht (ITO)
- 11: Sacklöcher
- 12: Metallschicht
- 13: Goldschicht
- 14: Antibenetzungsschicht

## Patentansprüche

1. Verfahren zur Erzeugung von vertikalen Durchkontaktierungen zur Herstellung von Halbleiter-Bauelementen, das heißt von Kontakten auf der Wafer-Vorderseite durch den Halbleiter-Wafer hindurch zur Wafer-Rückseite, wobei der Wafer ein Substrat (1) aus einem Substratmaterial und einen auf das Substrat (1) aufgebrachten elektrisch aktiven Schichtenstapel (2) mit einer GaN-Epitaxieschicht aufweist,
die folgenden Schritte umfassend:
- Laserbohren von Sacklöchern (11) an den Kontaktverbindungsstellen von der Wafer-Rückseite (6) her in das Halbleitersubstrat
- Reinigung des Wafers
- materialselektives Plasmaätzen des Halbleitersubstrates bis zum aktiven Schichtstapel des Wafers
- materialselektives Plasmaätzen des aktiven Schichtstapels (2) des Wafers bis zum Erreichen der mit der Wafer-Rückseite (6) zu verbindenden Kontakte
- Aufbringen einer Plattierbasis (12) auf die Wafer-Rückseite (6) und in die in einem vorhergehenden Schritt erzeugten Sacklöcher (11)
- galvanischer Goldauftrag (13) auf die metallisierte Wafer-Rückseite (6) und die in einem vorhergehenden Schritt mit einer Plattierbasis (12)versehenen Sacklöcher (11).

2. Verfahren nach Anspruch 1, **dadurch gekennzeichnet, dass**
vor dem Laserbohren der Sacklöcher (11) auf die Wafer-Vorderseite ein Schutzlack (9) aufgebracht wird, der nach dem Goldauftrag (13) wieder entfernt wird.

3. Verfahren nach Anspruch 1 oder 2, **dadurch gekennzeichnet, dass**
die Wafer-Rückseite (6) vor dem Laserbohren der Sacklöcher (11) mit Indium-Zinn-Oxid (ITO) beschichtet wird, das nach dem Goldauftrag (13) wieder entfernt wird.

4. Verfahren nach einem der Ansprüche 1 bis 3, **dadurch gekennzeichnet, dass**
die Reinigung nasschemisch mittels gepufferter Flusssäure erfolgt.

5. Verfahren nach einem der vorhergehenden Ansprüche, **dadurch gekennzeichnet, dass**
im Bereich der Eintrittsöffnungen der Durchgangslöcher an der Wafer-Rückseite (6) eine Antibenetzungsschicht (14) auf den galvanischen Goldauftrag (13) aufgebracht wird.

6. Verfahren nach Anspruch 5, **dadurch gekennzeichnet, dass** für die Antibenetzungsschicht (14) Titan verwendet wird.

7. Verfahren nach Anspruch 5 oder 6, **dadurch gekennzeichnet, dass** die Antibenetzungsschicht (14) aufgesputtert wird.

8. Verfahren nach einem der Ansprüche 5 bis 7, **dadurch gekennzeichnet, dass**
der Auftrag der Antibenetzungsschicht (14) mit Hilfe einer Schattenmaske erfolgt.

9. Verfahren nach einem der vorhergehenden Ansprüche, **dadurch gekennzeichnet, dass**
zum Laserbohren ein UV-Laser verwendet wird.

10. Verfahren nach einem der vorhergehenden Ansprüche, **dadurch gekennzeichnet, dass**
der Auftrag der Plattierbasis (12) durch Schrägaufdampfen erfolgt.

11. Verfahren nach einem der Ansprüche 1 bis 9, **dadurch gekennzeichnet, dass**
der Auftrag der Plattierbasis (12) durch Sputtern erfolgt.

12. Verfahren nach einem der Ansprüche 1 bis 9, **dadurch gekennzeichnet, dass**
der Auftrag der Plattierbasis (12) durch chemische Badabscheidung erfolgt.

13. Verfahren nach einem der vorhergehenden Ansprüche, **dadurch gekennzeichnet, dass**
zum Laserbohren ein Laser benutzt wird, dessen Strahl kleiner ist als die Querschnittsfläche des zu erzeugenden Sackloches (11), wobei der Strahl über den Bereich des Sackloches (11) bewegt wird.

14. Verfahren nach einem der vorhergehenden Ansprüche, **dadurch gekennzeichnet, dass**
das Plasmaätzen des Halbleitersubstrates durch ICP-Ätzen erfolgt.

15. Verfahren nach einem der vorhergehenden Ansprüche, **dadurch gekennzeichnet, dass**
das Plasmaätzen des aktiven Schichtenstapels (2) durch RIE-Ätzen erfolgt.

## Claims

1. A method for the production of vertical through-contacts for the fabrication of semiconductor components, i.e. extending from contacts on the front side of the wafer through the semiconductor wafer to the rear side of the wafer, wherein the wafer comprises a substrate (1) made of a substrate material and an electrically active layer stack (2) having a GaN epitaxial layer which is applied to the substrate (1),
comprising the following steps:
- Laser drilling of pocket holes (11) at the contacting sites from the rear side of the wafer (6) into the semiconductor substrate;
- Cleaning of the wafer;
- Material-selective plasma etching of the semiconductor substrate through to the active layer stack of the wafer;
- Material-selective plasma etching of the active layer stack (2) of the wafer until the contacts that are to be connected to the rear side of the wafer (6) are reached;
- Applying a plating base (12) to the rear side of the wafer (6) and to the inside of the pocket holes (11) produced in a preceding step;
- Applying gold by plating (13) to the metallized rear side of the wafer (6) and the pocket holes (11) equipped with a plating base (12) in a preceding step.

2. The method according to Claim 1, **characterized in that** before drilling the pocket holes (11) with the laser, a protective varnish (9) is applied to the front side of the wafer, said protective varnish being removed again following the gold application (13).

3. The method according to Claim 1 or 2, **characterized in that** before drilling the pocket holes (11) with the laser, the rear side of the wafer (6) is coated with indium tin oxide (ITO), said indium tin oxide being removed again following the gold application (13).

4. The method according to any one of Claims 1 to 3, **characterized in that**
cleaning occurs with wet chemistry by means of buffered hydrofluoric acid.

5. The method according to any one of the preceding claims, **characterized in that**
a dewetting layer (14) is applied to the plated gold application (13) in the region of the entry openings of the through-holes on the rear side of the wafer (6).

6. The method according to Claim 5, **characterized in that** titanium is used for the dewetting layer (14).

7. The method according to Claim 5 or 6, **characterized in that** the dewetting layer (14) is applied by sputtering.

8. The method according to any one of Claims 5 to 7, **characterized in that**
the application of the dewetting layer (14) takes place with the aid of a shadow mask.

9. The method according to any one of the preceding claims, **characterized in that**
a UV laser is used for laser drilling.

10. The method according to any one of the preceding claims, **characterized in that**
the plating base (12) is applied by oblique vapor deposition.

11. The method according to any one of Claims 1 to 9, **characterized in that**
the plating base (12) is applied by sputtering.

12. The method according to any one of Claims 1 to 9, **characterized in that**
the plating base (12) is applied by chemical bath deposition.

13. The method according to any one of the preceding claims, **characterized in that**
a laser is used for laser drilling, said laser having a beam that is smaller than the cross-sectional area of the pocket hole (11) that is to be produced, whereby the beam is moved across the area of the pocket hole (11).

14. The method according to any one of the preceding claims, **characterized in that**
plasma etching of the semiconductor substrate takes place by ICP etching.

15. The method according to any one of the preceding claims, **characterized in that**
plasma etching of the active layer stack (2) takes place by RIE etching.

## Revendications

1. Procédé de production de métallisation de trous verticaux pour la réalisation de composants semi-conducteurs, c'est-à-dire de contacts sur la face avant de plaquette à travers la plaquette semi-conductrice vers la face arrière de plaquette, la plaquette présentant un substrat (1) en matériau de substrat et une pile de couches (2) électriquement active mise en place sur le substrat (1) avec une couche épitaxiale GaN,
comprenant les étapes suivantes :
- perçage au laser de trous borgnes (11) aux points de liaison de contact à partir de la face arrière de plaquette (6) dans le substrat semi-conducteur
- nettoyage de la plaquette
- gravure au plasma par sélection de matière du substrat semi-conducteur jusqu'à la pile de couches active de la plaquette
- gravure au plasma par sélection de matière de la pile de couches (2) active de la plaquette jusqu'à ce que l'on atteigne les contacts à relier à la face arrière de plaquette (6)
- mise en place d'une base plaquée (12) sur la face arrière de plaquette (6) et dans les trous borgnes (11) produits dans une étape précédente
- application d'or (13) par voie galvanique sur la face arrière de plaquette (6) métallisée et sur les trous borgnes (11) munis d'une base plaquée (12) dans une étape précédente.

2. Procédé selon la revendication 1, **caractérisé en ce que**,
avant le perçage au laser des trous borgnes (11), un vernis de protection (9) est appliqué sur la face avant de plaquette et est ensuite enlevé après l'application d'or (13).

3. Procédé selon la revendication 1 ou 2, **caractérisé en ce que**,
avant le perçage au laser des trous borgnes (11), la face arrière de plaquette (6) est revêtue d'oxyde d'indium-étain (ITO) qui est enlevé ensuite après l'application d'or (13).

4. Procédé selon l'une des revendications 1 à 3, **caractérisé en ce que** le nettoyage s'effectue par voie chimique humide au moyen d'acide fluorhydrique tamponné.

5. Procédé selon l'une des revendications précédentes, **caractérisé en ce que**, dans la zone des ouvertures d'entrée des trous débouchants sur la face arrière de plaquette (6), une couche anti-mouillage (14) est appliquée sur l'application d'or (13) galvanique.

6. Procédé selon la revendication 5, **caractérisé en ce que** du titane est utilisé pour la couche anti-mouillage (14).

7. Procédé selon la revendication 5 ou 6, **caractérisé en ce que** la couche anti-mouillage (14) est déposée par pulvérisation.

8. Procédé selon l'une des revendications 5 à 7, **caractérisé en ce que** l'application de la couche anti-mouillage (14) s'effectue à l'aide d'un masque perforé.

9. Procédé selon l'une des revendications précédentes, **caractérisé en ce qu'**un laser UV est utilisé pour le perçage au laser.

10. Procédé selon l'une des revendications précédentes, **caractérisé en ce que** l'application de la base plaquée (12) s'effectue par dépôt par évaporation oblique.

11. Procédé selon l'une des revendications 1 à 9, **caractérisé en ce que** l'application de la base plaquée (12) s'effectue par pulvérisation.

12. Procédé selon l'une des revendications 1 à 9, **caractérisé en ce que** l'application de la base plaquée (12) s'effectue par dépôt en bain chimique.

13. Procédé selon l'une des revendications précédentes, **caractérisé en ce que**, pour le perçage au laser, il est utilisé un laser dont le faisceau est plus petit que la surface de section transversale du trou borgne (11) à produire, le faisceau étant déplacé au-dessus de la zone du trou borgne (11).

14. Procédé selon l'une des revendications précédentes, **caractérisé en ce que** la gravure au plasma du substrat semi-conducteur s'effectue par gravure ICP.

15. Procédé selon l'une des revendications précédentes, **caractérisé en ce que** la gravure au plasma de la pile de couche (2) active s'effectue par gravure RIE.
